(19) **Europäisches Patentamt / European Patent Office / Office européen des brevets**

(11) **EP 1 524 507 B1**

(12) **FASCICULE DE BREVET EUROPEEN**

(45) Date de publication et mention de la délivrance du brevet:
**13.05.2009 Bulletin 2009/20**

(51) Int Cl.:
*G01J 5/20* (2006.01)   *H01L 27/146* (2006.01)

(21) Numéro de dépôt: **04300670.9**

(22) Date de dépôt: **08.10.2004**

(54) **Détecteur bolométrique, dispositif de détection infrarouge mettant en oeuvre un tel détecteur bolométrique et procédé de fabrication de ce détecteur**

Bolometer, Infrarotdetektionsvorrichtung diese anwendend und Verfahren zur Herstellung davon

Bolometer, infra-red detection apparatus using it and means of manufacture

(84) Etats contractants désignés:
**DE FR GB IT SE**

(30) Priorité: **15.10.2003 FR 0312042**

(43) Date de publication de la demande:
**20.04.2005 Bulletin 2005/16**

(73) Titulaire: **ULIS**
**38113 Veurey Voroize (FR)**

(72) Inventeur: **Vilain, Michel**
**38450, SAINT GEORGES DE COMMIERS (FR)**

(74) Mandataire: **Vuillermoz, Bruno et al**
**Cabinet Laurent & Charras**
**"Le Contemporain"**
**50, Chemin de la Bruyère**
**69574 Dardilly Cédex (FR)**

(56) Documents cités:
**WO-A-00/37906**     **US-A- 5 399 897**
**US-A- 5 912 464**

**Description**

La présente invention concerne un détecteur bolométrique, ainsi que le dispositif de détection infrarouge mettant en oeuvre un tel détecteur. Elle concerne également le procédé de réalisation d'un tel détecteur.

L'invention trouve notamment son domaine d'application dans l'imagerie infrarouge.

Dans le domaine des détecteurs infrarouges, il est connu des dispositifs agencés sous forme matricielle, et susceptibles de fonctionner à la température ambiante, c'est à dire ne nécessitant pas de refroidissement, contrairement aux dispositifs de détection appelés détecteurs quantiques, qui eux nécessitent un fonctionnement à très basse température, typiquement celle de l'azote liquide.

Ces détecteurs non refroidis utilisent traditionnellement la variation d'une grandeur physique d'un matériau approprié, en fonction de la température au voisinage de 300 K. Dans le cas des détecteurs bolométriques, cette grandeur physique est la résistivité électrique.

Un tel détecteur non refroidi associe généralement :

- des moyens d'absorption du rayonnement infrarouge et de conversion de ce dernier en chaleur ;
- des moyens d'isolation thermique du détecteur, de telle sorte à permettre à celui-ci de s'échauffer sous l'action du rayonnement infrarouge ;
- des moyens de thermométrie, qui dans le cadre d'un détecteur bolométrique mettent en oeuvre un élément résistif ;
- et des moyens de lecture des signaux électriques fournis par les moyens de thermométrie.

Les détecteurs destinés à l'imagerie infrarouge sont réalisés sous la forme d'une matrice de détecteurs élémentaires selon une ou deux dimensions, sur un substrat, généralement réalisé en silicium, qui comporte des moyens d'excitation électrique desdits détecteurs élémentaires, et des moyens de pré-traitement des signaux électriques générés par ces détecteurs élémentaires.

Ces moyens d'excitation électrique et de pré-traitement sont formés sur le substrat et constituent un circuit de lecture.

L'intégration monolithique des détecteurs au circuit de lecture correspondant est avantageuse du point de vue des coûts de fabrication. Toutefois, il est également possible d'hybrider une matrice de détecteur sur un tel circuit de lecture.

Un dispositif comportant une matrice de détecteurs élémentaires et un circuit de lecture associé est généralement placé dans un boîtier et relié, notamment électriquement, au milieu extérieur par des techniques classiques. Dans un tel boîtier, la pression est réduite afin de limiter les pertes thermiques. Ce boîtier est en outre muni d'une fenêtre infrarouge transparente au rayonnement à détecter.

Pour observer une scène par l'intermédiaire de ce détecteur, on projette la scène à travers une optique adaptée sur la matrice de détecteurs élémentaires, et les stimuli électriques cadencés sont appliqués, par l'intermédiaire du circuit de lecture (également prévu à cet effet), à chacun des détecteurs élémentaires, ou à chaque rangée de tels détecteurs, afin d'obtenir un signal électrique constituant l'image de la température atteinte par chaque détecteur élémentaire.

Ce signal est traité de manière plus ou moins élaborée par le circuit de lecture, puis éventuellement par un dispositif électronique extérieur au boîtier, afin de générer une image thermique de la scène observée.

Les performances des détecteurs bolométriques non refroidis dépendent essentiellement :

- de la maîtrise d'élaboration et d'intégration des matériaux bolométriques les plus performants ;
- de la maîtrise de conception et de construction des détecteurs élémentaires, sous la forme de micro-ponts, c'est à dire de structures légères et fragiles isolées thermiquement du circuit de lecture ;
- de la qualité de mise en oeuvre de ces détecteurs et des diverses fonctions de correction qui sont utilisées dans le circuit de lecture et dans d'autres dispositifs annexes ;
- et de la maîtrise des techniques de conditionnement dans un boîtier étanche sous faible pression.

La présente invention est plus particulièrement orientée vers la maîtrise de conception et de construction des micro-ponts. Elle vise en effet à permettre l'obtention de détecteurs bolométriques très performants, à l'aide de techniques relativement simples à mettre en oeuvre.

L'art antérieur décrit diverses manières de disposer les divers éléments constitutifs des détecteurs élémentaires.

On distingue principalement les détecteurs à électrodes coplanaires, et les détecteurs à électrodes parallèles (structure dit « sandwich »). On a par exemple décrit dans le document US-A-5 021 663, un détecteur bolométrique du type en question.

Bien que l'invention trouve plus aisément application dans les détecteurs à électrodes coplanaires, dans lesquels le courant électrique qui traverse la structure en fonctionnement, circule dans le plan du détecteur élémentaire,

**EP 1 524 507 B1**

elle est également d'application dans les détecteurs à électrodes parallèles.

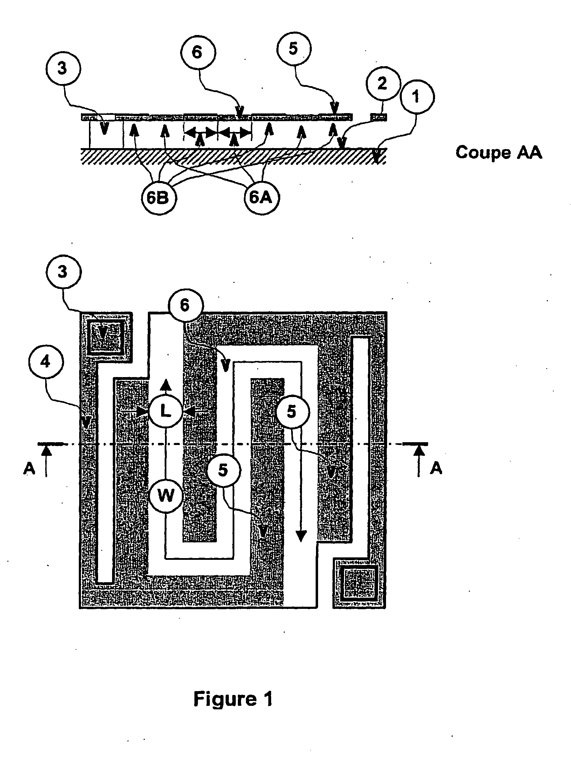

On a décrit dans le document FR-A-2 752 299, un détecteur bolométrique comportant un circuit de lecture et un ou plusieurs détecteurs élémentaires comportant eux-mêmes une partie sensible intégrant notamment une couche de matériau bolométrique ainsi que deux électrodes conductrices, et au moins un élément support de cette partie sensible, et dans laquelle les électrodes sont inter-digitées. On a schématiquement représenté sur la figure 1, une représentation de ce détecteur bolométrique élémentaire.

Au sein de celui-ci, le circuit de lecture (1) est recouvert d'une couche métallique réfléchissante (2), destinée à renvoyer le rayonnement infrarouge non absorbé par le bolomètre lui-même, et situé à environ 1,5 à 2,5 micromètres au-dessus dudit réflecteur (et ce, afin d'optimiser la détection autour de 10 micromètres de longueur d'onde, correspondant sensiblement à la plage utile de détection de ces détecteurs).

Ce positionnement s'effectue au moyen de structures essentiellement verticales (3). Ces structures, que l'on dénommera piliers dans la suite de la description, sont elles-mêmes conductrices de l'électricité, et permettent ainsi d'amener les potentiels d'excitation vers les parties conductrices ou électrodes (5) du détecteur bolométrique, via des structures planes allongées (4), également conductrices électriquement, mais résistantes thermiquement. Ces structures planes allongées seront dénommées bras dans la suite de la description.

Cette résistance thermique, dite également « isolation thermique », est destinée à permettre l'échauffement du matériau bolométrique sous l'effet du rayonnement infrarouge.

Le volume entre le corps du bolomètre et le réflecteur est vide de matière, en dehors des piliers (3) et ce, afin d'éviter les pertes thermiques par conduction solide. Ce volume est habituellement rempli par une faible pression de gaz, afin de limiter la convection et la conduction par les gaz.

Dans ce type de dispositif, le circuit de lecture applique, via les piliers (3) et les bras (4), et via au moins deux parties conductrices ou électrodes (5), un courant électrique qui traverse la structure parallèlement au plan du détecteur bolométrique. Ce courant circule à travers un matériau bolométrique (6), dont la résistivité varie avec la température. Les matériaux les plus répandus pour cet usage sont l'oxyde de vanadium et le silicium amorphe.

Les électrodes (5) sont réalisées à l'aide d'une couche fine conductrice, ordinairement métallique. Elles servent également à réaliser l'absorption du rayonnement infrarouge. On peut observer sur la figure 1 le fait que ces électrodes sont disposées sur la surface supérieure du matériau bolométrique (6). La surface interne suspendue du bolomètre, c'est à dire hors piliers (3) et bras (4) de la figure 1, se présente pratiquement toujours sous la forme de surfaces pratiquement équipotentielles (5) et de surfaces résistives, d'extension définie par les espaces entre les parties (5). Dans la suite de la description, on distinguera les parties (6A) et (6B) de la couche de matériau bolométrique (6), selon qu'elles sont traversées par le courant d'excitation (6A) ou non traversées par un tel courant (6B).

La performance d'un détecteur bolométrique est exprimée traditionnellement par la résolution thermique NedT (pour l'expression en langue anglaise *« Noise Equivalent Differential Temperature »*).

On démontre, dans l'hypothèse où le niveau de polarisation est suffisant pour que le bruit électrique dans le détecteur soit dominé par le bruit basse fréquence (Bbf), dit en « 1/f », caractéristique en particulier des matériaux amorphes que la résolution thermique se quantifie par la relation :

$$\frac{1}{NedT} = k.(W.L.E)^{1/2} . TCR.Rth$$

dans laquelle :

. K est un paramètre de proportionnalité qu'il n'est pas utile de détailler ici, qui intègre la bande passante du circuit de lecture, le niveau de bruit basse fréquence « en 1/f» du matériau bolométrique (6), la surface du détecteur élémentaire, et l'efficacité d'absorption infrarouge du détecteur élémentaire ;

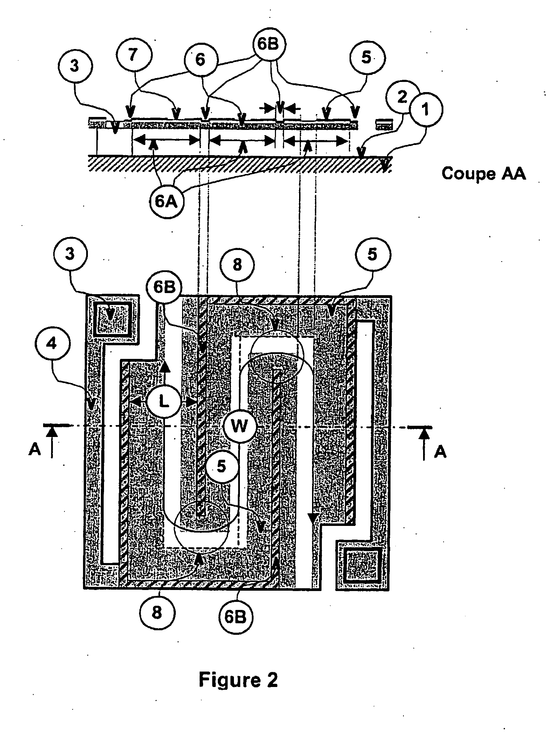

. W et L sont respectivement les largeur et longueur électrique des lignes de courant à travers le matériau bolométrique (6), que l'on retrouvera sur les figures 1 et 2 ;

. E est l'épaisseur du matériau bolométrique (6) sur la surface concernée par les lignes de courant limitée par les dimensions W et L ;

. TCR est la variation relative de résistance au voisinage de la température de fonctionnement (dR/RdT), caractéristique du matériau bolométrique mis en oeuvre, où R est la résistance électrique vue entre les deux pôles d'amenée du courant (les deux piliers (3)) et T la température du micro-pont ;

. Rth est la résistance thermique entre la partie centrale « massive » du bolomètre qui s'échauffe sous l'effet du rayonnement infrarouge, et le circuit de lecture (1), dont la température est constante ou très lentement variable.

Cette hypothèse est justifiée par le fait que la résolution thermique dérive du calcul de S/B, où S est le signal

3

fourni par le détecteur, et B le bruit électrique.

Le signal de détection S, proportionnel au courant électrique i qui traverse le bolomètre (S = $K_1$ . i), doit être maximal, alors que le bruit basse fréquence est également proportionnel à i (Bbf = $K_2$ . i).

Ainsi, lorsque l'on augmente le courant électrique pour améliorer le signal, arrive un moment où le bruit basse fréquence (Bbf) est prépondérant devant les autres sources de bruit indépendantes de la valeur du courant, dont typiquement le bruit « blanc » (indépendant de la fréquence), généré par le détecteur bolométrique.

Le rapport signal sur bruit est optimal, lorsqu'il s'approche de sa valeur limite $K_1/K_2$ pour une valeur suffisante du courant d'excitation, même pour des matériaux naturellement peu bruyants à basse fréquence.

Le bolomètre est donc typiquement dominé par le bruit en 1/f dans les conditions de polarisation qui optimisent la résolution thermique NedT.

Ces différents éléments quantificatifs peuvent être retrouvés dans le document FR-A-2 796 148.

Il ressort de cette relation que la performance en termes de détection des détecteurs bolométriques est liée au volume de matériau bolométrique concerné par les lignes de courant d'excitation, c'est à dire est égale au produit de la surface (W . L) des parties résistives (6A) par l'épaisseur E dudit matériau bolométrique.

Les parties (6B) du matériau bolométrique, c'est à dire non traversées par le courant d'excitation, ne participent pas à la définition de la performance de détection du détecteur bolométrique, car pratiquement aucun courant ne traverse ledit matériau bolométrique à ce niveau, ces zones étant beaucoup plus résistives électriquement que les couches définissant les parties (5).

Dans le cadre d'une matrice de détection, on définit par p le pas de répétition du détecteur élémentaire selon les deux dimensions du plan.

Afin d'aboutir à une performance de détection optimale, il suffit, selon l'analyse qui précède, de disposer des parties (6A) selon un polygone de longueur L et de largeur W, avec L . W = $p^2$, pour optimiser la performance de détection.

Cette grandeur $p^2$ représente la borne supérieure du paramètre L . W, car sur le plan technique, il convient de réserver une partie de l'aire $p^2$ pour disposer des espaces de séparation des détecteurs élémentaires entre eux, et au moins les piliers (3) et bras (4) et les zones (6B), dont l'aire ne peut pas être nulle.

Ces grandeurs L et W selon une disposition typique, ont été représentées sur la figure 1.

On observe cependant que l'absorption des rayonnements infrarouges diminue rapidement lorsque l'aire des électrodes (5) est réduite au profit de l'aire des surfaces (6A).

En pratique, la meilleure performance en termes de résolution bolométrique est obtenue lorsque l'on atteint l'équilibre entre les aires des électrodes (5) et des zones (6A).

Il en résulte que la moitié environ de l'aire interne du bolomètre (les parties 6B) n'est pas utilisable pour optimiser les lignes de courant, c'est à dire maximaliser l'aire totale L.W du ou des polygones traversés par les lignes de courant.

L'évaluation de la résolution bolométrique NedT montre également que la performance s'améliore si l'on augmente l'épaisseur E de la couche de matériau bolométrique (6), au même titre que les dimensions des grandeurs W et L.

Cependant, cette augmentation d'épaisseur augmente d'autant la masse thermique Cth du bolomètre, cette masse thermique entrant dans la définition de la constante de temps thermique par la relation τth = Cth . Rth, qui constitue également l'un des paramètres importants du point de vue de l'utilisation du détecteur bolométrique, car elle définit la vitesse maximale selon laquelle le détecteur en question est susceptible de suivre une variation de température d'un point de la scène observée.

Selon le document FR-A-2 752 299, la masse thermique totale du détecteur bolométrique est largement déterminée par la masse du matériau bolométrique (6), et une augmentation d'épaisseur de cette couche s'accompagne d'une augmentation presque proportionnelle de la masse thermique globale.

De fait, le gain en résolution thermique NedT procuré par cette épaisseur plus élevée de matériau bolométrique est compensée par l'augmentation de la constante de temps thermique τth. L'optimisation globale du bolomètre suppose donc que la constante de temps thermique, et donc l'épaisseur de la couche de matériau bolométrique (6) est ajustée à la valeur maximale compatible avec la fréquence de mise en oeuvre envisagée par l'utilisateur.

En d'autres termes, l'épaisseur du matériau bolométrique n'est donc pas un paramètre libre d'optimisation.

De fait, le détecteur bolométrique selon le document FR-A-2 752 299 ne peut être amélioré en termes de résolution thermique de par la nécessaire prise en compte de la constante de temps thermique, pour permettre une utilisation efficace d'un tel détecteur bolométrique.

Afin d'améliorer la résolution thermique d'un détecteur bolométrique, le document FR-A-2 796 148 précité propose une configuration visant à relâcher la contrainte liée à la qualité d'absorption du rayonnement et d'équilibrage des aires des électrodes (5) et des zones (6A) du matériau bolométrique.

Selon les enseignements de ce document, les parties (6B) de contact entre les électrodes (5) et le matériau bolométrique (6) sont réduites à de petites surfaces allongées et étroites. En outre, les électrodes (5) sont isolées du matériau bolométrique sur l'essentiel de leur surface, par l'intercalation d'une couche isolante (7).

Cette technique permet d'utiliser la majeure partie des surfaces (6B) à l'optimisation du ou des polygones d'aire (W . L), et d'obtenir ainsi une amélioration substantielle de performances.

Cependant, ce résultat est obtenu d'une part, par l'adjonction d'une masse supplémentaire liée à la mise en oeuvre du matériau isolant (7), d'autre part, résulte d'une complexité additionnelle d'élaboration non négligeable. Il présente l'inconvénient en outre d'aboutir à un déficit de performance du fait du resserrement des lignes de courant autour des extrémités des parties (6B), dans le cas où l'électrode (5) présente une configuration inter-digitée, telle que représentée sur la figure 2.

Or, ce type de configuration est pratiquement inévitable pour la mise en oeuvre de matériau bolométrique à haute résistivité, comme le silicium amorphe et les matériaux apparentés, pour obtenir une résistance électrique R de quelque $10^5$ à $10^6$ Ohms, pratique du point de vue du circuit de lecture.

Il convient en effet de rappeler que l'une des difficultés auxquelles doit faire face l'homme de métier pour la définition des structures d'un détecteur bolométrique, est la constitution d'une résistance électrique R au voisinage de la température ambiante adaptée aux possibilités du circuit de lecture.

En effet, n'importe quelle valeur de résistance n'est pas nécessairement pratique à mettre en oeuvre, avec le type de circuit de lecture que le concepteur du système entend utiliser, et il est en général plus pratique, pour optimiser les fonctions du circuit de lecture que cette résistance R soit déterminée par des contraintes propres à ce circuit, plutôt que par des contraintes générées par le détecteur bolométrique en tant que tel.

En négligeant les résistances constituées par les piliers (3) et les bras (4), cette résistance est définie par la relation :

$$R = \rho \cdot L / (W.E)$$

où $\rho$ est la résistivité électrique du matériau bolométrique au voisinage de la température de fonctionnement.

La configuration de l'électrode (5) définit directement les largeur W et longueur L et l'inter-digitation, comme par exemple représentée sur les figures 1 et 2 et offre un certain degré de liberté.

Mais les variations possibles de l'inter-digitation des électrodes (5) ne sont en pratique pas très nombreuses sur les surfaces $p^2$ habituellement mises en oeuvre (moins de 50 x 50 $\mu m^2$) et avec un pas (largeur + espace) de dessins d'électrode supérieur à environ 8 $\mu m$, pour éviter les phénomènes de diffractions entre 8 et 14 $\mu m$ de longueur d'onde, c'est à dire dans la zone de longueur d'onde correspondante à l'imagerie infrarouge.

La configuration des lignes de courant dans le cadre de la figure 2 peut être modélisée par d'une part, les trois zones rectangulaires bordées par les parties (6B) dans leur portion rectiligne parallèle, d'autre part, les deux zones (8) correspondant aux extrémités des parties (6B) internes au détecteur bolométrique.

Dans les zones rectangulaires, la densité des lignes de courant est uniforme et des grandeurs locales $W_r$ et $L_r$ sont immédiatement définies, dans lesquelles l'indice r se rapporte aux zones rectangulaires.

Ces zones définissent une résistance électrique égale à Rs . L/W, où $R_s$ est la résistance de couche (sheet resistance) ($R_s = \rho / E$) du matériau bolométrique.

Dans les zones (8) par contre, la densité des lignes de courant est variable, à savoir nettement plus élevée au voisinage des pointes des zones (6B) qu'à l'intérieur des zones rectangulaires, et nettement plus faible au voisinage de la partie (6B) opposée.

Si l'on regroupe les deux zones (8) sous la forme d'un disque de rayon interne $r_1$, en posant $r_1$ comment étant le rayon des pointes des deux zones (6B), alors le rayon externe de ces zones s'écrit $L+r_1$. En pratique, $r_1$ peut être assimilé à la demi-largeur du motif allongée des parties (6B) de la figure 2.

Il est aisé de démontrer que la résistance électrique de ce disque est donnée par la relation :

$$\frac{Rs}{2\pi} . \ln \frac{L + r_1}{r_1}$$

La largeur Wp du rectangle de longueur L équivalent aux zones (8), où l'indice p se rapporte aux zones de pointes, est donnée par la relation :

$$\frac{RsL}{Wp} = \frac{Rs}{2\pi} . \ln \frac{L + r_1}{r_1} \text{ soit } Wp = 2\pi . L / \ln \frac{L + r_1}{r_1}$$

Selon l'exemple de la figure 2, pour un bolomètre de 35 $\mu m$ de dimension hors tout, y compris l'espace entre détecteurs bolométriques voisins avec L = 6,5 $\mu$m et $r_1$ = 0,5 $\mu$m par exemple, il en résulte une largeur électrique équivalente $W_p$ = 15,5 $\mu$m (pour l'ensemble des deux zones (8)), sensiblement inférieure à la longueur du tracé rectangulaire (en pointillés sur la figure 2), qui représenterait la largeur électrique W maximale utilisable au voisinage des zones (8) pour optimiser le produit W.L, et donc la résolution thermique du bolomètre. Cette longueur du tracé rectangulaire serait de fait voisine de 28 $\mu$m selon l'échelle de l'exemple réaliste représenté en figure 2. La largeur « électrique » totale effective W = Wp + Wr (en trait plein le long de l'équipotentielle centrale entre les parties (6B)) serait voisine de 60 $\mu$m pour une largeur électrique maximale (représentée en traits pointillés) de 73 $\mu$m environ. Cet écart représente une perte de 11 % environ de performance par rapport à un détecteur bolométrique idéal, qui ne présenterait pas d'effets de pointes localisés.

En résumé, la configuration proposée dans ce document, outre les inconvénients déjà mentionnés, est susceptible d'amélioration au niveau de la résolution thermique du détecteur bolométrique.

On a également décrit dans le document US-A-5 367 167 un détecteur bolométrique comprenant deux électrodes coplanaires situées sur la même face de la couche de matériau bolométrique, ainsi qu'une couche conductrice située sur l'autre face de cette couche de matériau bolométrique. Cette couche conductrice a pour fonction d'absorber le rayonnement infrarouge que l'on souhaite détecter et doit être séparée du corps du détecteur par une couche électriquement isolante. Il s'avère donc d'une complexité élevée pour sa réalisation. Par ailleurs, la disposition des électrodes de manière éloignée réduit l'application de ce détecteur bolométrique aux matériaux bolométriques de faible résistivité, tels typiquement les oxydes de vanadium.

L'objet de la présente invention consiste en un détecteur bolométrique de construction simple, dont la distribution de masse du matériau bolométrique sur la surface du détecteur élémentaire est maîtrisée, afin que la totalité ou la quasi-totalité de la masse dudit matériau bolométrique soit traversée par des lignes de courant, et ce, dans le but d'aboutir à un meilleur niveau de performance à dimensions et constante de temps thermique données. Elle vise également à offrir un degré supplémentaire d'ajustement de la résistance électrique, à performance constante.

Ce détecteur bolométrique comprend :

- une partie sensible comportant un circuit de lecture formé dans un substrat, au dessus duquel sont disposés :

    . une ou plusieurs couches d'un matériau sensible, dont la résistivité varie avec la température ;
    . des électrodes isolées les unes des autres faisant en outre fonction d'absorbeur du rayonnement infrarouge, lesdites électrodes étant en contact avec le matériau sensible sur au moins une partie de leur surface ;

- au moins une zone support de la partie sensible, faisant fonction de positionnement de la dite partie sensible, et de conducteur électrique en relation avec un circuit de lecture associé au détecteur bolométrique,
- au moins une structure d'isolement thermique reliant électriquement et mécaniquement chaque zone support à la partie sensible.

Il se caractérise :

- en ce que les zones de matériau sensible non en contact avec les électrodes, présentent au moins une ondulation dans la direction perpendiculaire au plan contenant la partie sensible du détecteur bolométrique ;
- et en ce que le matériau sensible bolométrique est constitué de silicium amorphe ou d'un alliage apparenté de type $Si_xGe_yC_z$ où x + y + z = 1.

Ainsi, là où l'état antérieur de la technique met en oeuvre une surface plane, l'invention met en oeuvre une ou plusieurs ondulations, permettant d'augmenter significativement la quantité de matériau bolométrique traversée par les lignes de courant, et ce faisant, optimise les performances du détecteur, notamment en termes de résolution thermique, sans pour autant augmenter la masse de matériau bolométrique.

Enoncé encore de manière différente, l'invention consiste à augmenter la proportion utile du volume total de matériau bolométrique à constante de temps $\tau$th conservée. On rappelle en effet que l'augmentation de l'épaisseur dudit matériau bolométrique en vue d'augmenter le volume utile de ce matériau n'est pas un paramètre libre d'optimisation, compte tenu de l'augmentation alors corrélative de cette constante de temps.

Selon l'invention, ces ondulations peuvent être parallèles ou perpendiculaires ou les deux à la fois sur des zones disjointes aux lignes de courant qui traversent la structure, en fonctionnement. Elles peuvent encore être obliques par rapport auxdites lignes de courant.

Selon l'invention, l'amplitude des ondulations est inférieure à la distance séparant les électrodes du substrat constitutif du circuit de lecture, et est notamment au plus égale à 1,5 $\mu$m.

L'invention concerne également un dispositif de détection infrarouge mettant en oeuvre un tel détecteur bolométrique. Avantageusement, le ou les détecteurs sont solidarisés au circuit de lecture au moyen d'une structure de type pilier (3). En outre, ce dispositif présente une structure matricielle comportant au moins deux détecteurs bolométriques.

Elle concerne également un procédé de fabrication d'un tel détecteur bolométrique.

La manière dont l'invention peut être réalisée et les avantages qui en découlent ressortiront mieux des exemples de réalisation qui suivent, donnés à titre indicatif et non limitatif à l'appui des figures annexées.

La figure 1 est comme déjà dit une illustration d'un détecteur bolométrique élémentaire conforme à l'art antérieur.

La figure 2 est également une représentation schématique d'un détecteur bolométrique conforme à l'art antérieur.

La figure 3a est une représentation schématique d'un détail d'un détecteur bolométrique conforme à une première forme de réalisation de l'invention, vue en plan et en coupe.

La figure 3b est une représentation schématique d'un détail d'un détecteur bolométrique conforme à une seconde forme de réalisation de l'invention, représenté en plan et en coupe.

La figure 4 est une représentation schématique d'un détecteur bolométrique conforme à l'invention, mise en oeuvre au sein du détecteur bolométrique de la figure 1.

La figure 5 est une représentation schématique d'un détecteur bolométrique conforme à l'invention, mis en oeuvre selon les techniques du détecteur bolométrique de la figure 2.

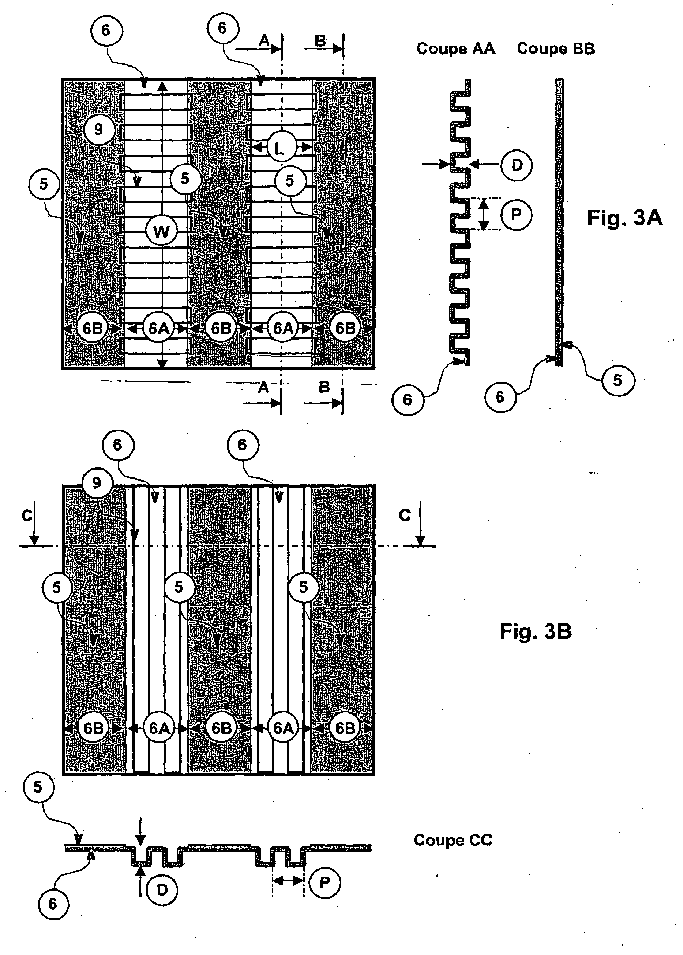

On a donc représenté en relation avec la figure 3a la partie centrale d'un détecteur bolométrique conforme à l'invention, notamment la partie sensible au rayonnement infrarouge qu'un tel détecteur est destiné à détecter.

Au sein de cette partie centrale, les parties (6A) du matériau bolométrique, c'est à dire les parties exemptes d'électrodes (5) comportent sur toute leur surface des ondulations (9) orientées perpendiculairement au plan comportant ladite partie sensible, et tel qu'on peut l'observer sur la coupe A-A, figurant au regard de la figure 3a.

Ces ondulations sont définies par un pas P et une amplitude D. Si F est défini comme étant le rapport entre la longueur déployée d'une ondulation (9) et le pas P, la mise en oeuvre de telles ondulations (9), dans l'exemple décrit, orienté parallèlement au sens du courant, induit une diminution de résistance R, à épaisseur et résistivité de matériau bolométrique constantes dans le rapport F, outre à une amélioration de la résolution thermique NedT, dans le rapport $F^{1/2}$.

Dans la forme de réalisation représentée en relation avec la figure 3b, les ondulations (9) sont orientées perpendiculairement au sens du courant. Selon cette configuration, on aboutit à une augmentation de la résistance R dans le rapport F, et une amélioration de la résolution thermique NedT également dans le rapport $F^{1/2}$.

Si les représentations schématiques desdites ondulations, respectivement selon les coupes A-A, et C-C, illustrent une forme parfaitement rectangulaire, ceci n'est en réalité techniquement pas le cas, compte-tenu des propriétés de détail des techniques de réalisation. Cependant, les ondulations mises en oeuvre techniquement permettent d'aboutir à des résultats du même ordre.

A titre exemplatif, il peut être mis en oeuvre une ondulation d'un pas de 2 $\mu$m et de profondeur ou amplitude D de 1 $\mu$m, facilement réalisable sur un microbolomètre typique pour une imagerie de 20 à 50 $\mu$m d'arête, et ce pour toutes les parties (6A), c'est à dire les espaces résistifs positionnés entre les électrodes (5) équipotentielles.

Dans cette hypothèse, on aboutit à une augmentation des résistances R d'un facteur 2, et à une amélioration de performance de résolution thermique de $2^{1/2}$, soit de 40 % environ, tout à fait significative dans le domaine d'application de la présente invention.

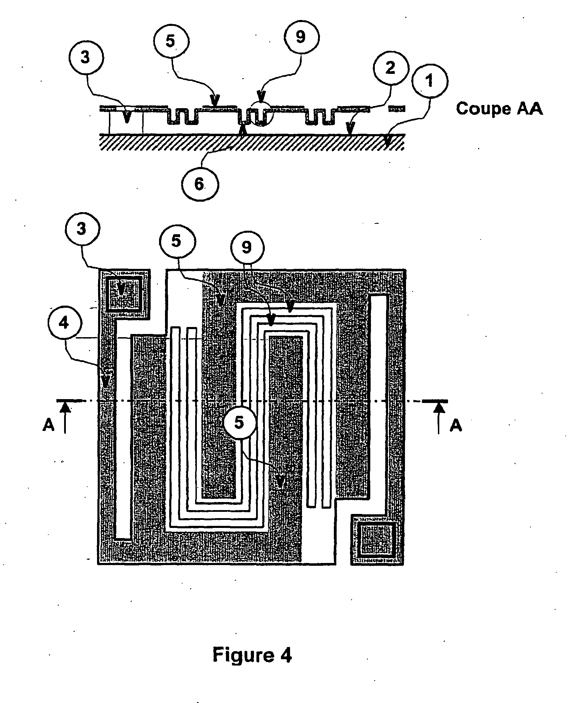

La figure 4 illustre l'application de l'invention au détecteur bolométrique de la figure 1, c'est à dire le détecteur bolométrique reproduisant les enseignements du document FR-A-2 752 299, en l'espèce selon la forme de réalisation définie dans la figure 3b.

Il pourrait cependant tout aussi bien être envisagé de mettre en oeuvre la forme de réalisation de la figure 3a, voire à mettre en oeuvre sur un même détecteur bolométrique une forme de réalisation des figures 3a et 3b dans l'objectif d'ajuster localement la densité des lignes de courant, en tenant compte de l'espacement local des électrodes (5) ou en ajustant en conséquence cet espacement.

Ainsi, il est possible de diminuer localement la densité de courant en insérant un ou plusieurs segments d'ondulation orientés perpendiculairement au sens du courant, et corollairement augmenter localement la densité de courant en insérant un ou plusieurs segments d'ondulation orientés parallèlement au sens du courant. L'objectif recherché est d'obtenir une densité de courant sensiblement uniforme en tout point des zones (6A).

En outre, toujours selon l'invention, on peut prévoir la mise en oeuvre localement d'un ou de plusieurs segments d'ondulation orientés obliquement par rapport aux lignes de courant, si l'on souhaite aboutir à une valeur de résistance proche de la résistance obtenue en l'absence d'ondulation.

Dans la forme de réalisation décrite en relation avec la figure 4, l'objectif est de rechercher une amélioration de la résolution thermique NedT à épaisseur E de matériau bolométrique constante.

Ce faisant, cette configuration permet de conserver la résistance thermique constante, notamment dans le cas où les structures (4) d'isolation thermique sont essentiellement constituées par la couche de matériau bolométrique (6).

Dans cette configuration, la masse thermique ainsi que la constante de temps $\tau$th est augmentée en négligeant la masse thermique de l'électrode (5) d'une valeur relative égale à:

$$1 + (F - 1) \cdot W \cdot L/S$$

où S désigne l'aire de la partie interne du bolomètre où le matériau bolométrique (6) est présent, c'est à dire la somme des aires des parties (6A) et (6B).

Selon la configuration de la figure 4, la valeur W.L/S est voisine de 0,4, et pour une valeur raisonnable du rapport F = 2, la constante de temps thermique est augmentée de 40%, pour une amélioration de la résolution thermique NedT du même ordre.

Les configurations de l'art antérieur, telles que représentées sur la figure 1, pourraient permettre d'aboutir à cette même amélioration du facteur W.L.E, en augmentant l'épaisseur du matériau bolométrique d'un facteur 2. Cependant, la mise en oeuvre d'une telle épaisseur du matériau bolométrique aurait abouti à un doublement de la masse thermique, et corollairement à une diminution d'un facteur 2 de RTh, dans l'hypothèse où les bras (4) sont essentiellement constitués de la couche (6).

Globalement, la constante de temps thermique serait conservée, mais la résolution thermique NedT serait détériorée d'un facteur $2^{1/2}$.

En mettant en oeuvre l'invention au niveau d'un détecteur bolométrique du type de celui représenté en figure 1, on peut aboutir à constante de temps thermique constante, à une amélioration de la résolution thermique, tout en procédant à une diminution d'épaisseur de la couche de matériau bolométrique de 30 % environ.

Cette amélioration de la résolution thermique NedT est alors d'environ 18%, c'est à dire d'une valeur tout à fait significative dans le domaine considéré, et ce, du simple fait de l'adjonction des ondulations.

L'amélioration de la résolution thermique NedT est de l'ordre de 54 % si l'on prend en compte l'augmentation de RTh résultant de la diminution d'épaisseur de la couche (6).

Dans le cas plus général où les structures d'isolation (4) sont réalisées de manière essentiellement indépendantes de l'épaisseur de la couche de matériau bolométrique (6), ce qui suppose une architecture de construction nettement plus complexe, et réalisées de telle sorte à maintenir la RTh de référence, on a alors intérêt à diminuer l'épaisseur de ladite couche (6) de matériau bolométrique dans la partie centrale du bolomètre, et simultanément, augmenter le facteur d'ondulation F pour maintenir constante la masse de matériau bolométrique (donc $\tau$th), tout en améliorant la résolution thermique.

Ainsi et pour maintenir une telle masse constante de matériau bolométrique, tout en obtenant une amélioration optimale de la résolution thermique NedT, il convient de mettre en oeuvre des techniques nécessaires pour obtenir un facteur F aussi élevé que possible, et diminuer l'épaisseur E d'un facteur {1+ (F - 1) . W . L/S}

Avec une valeur de W.L/S de 0,4 comme retenue précédemment comme valeur typique, un facteur F de 3,5 associé à une diminution d'épaisseur de la couche de matériau bolométrique d'un facteur 2 améliore la résolution thermique NedT résultante d'environ 32%, par rapport à l'état antérieur de la technique à $\tau$th constant.

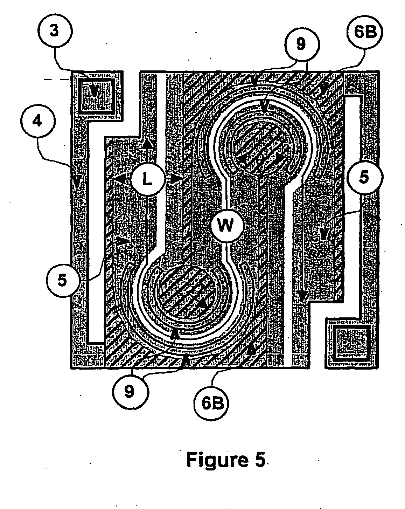

Selon une autre forme de réalisation de l'invention, représentée en figure 5, on met en oeuvre l'invention selon la configuration du détecteur bolométrique de l'art antérieur tel qu'illustré sur la figure 2.

Plus précisément, les extrémités des zones étroites (6B) ont été modifiées par rapport à cet état antérieur de la technique, notamment par l'insertion d'un disque ou d'un polygone sensiblement régulier, de rayon $r_2$, sensiblement plus élevé que la moitié de la largeur de la partie allongée (6B) (notée $r_1$ précédemment).

La partie (6B) opposée est préférentiellement arrondie ou polygonale, ainsi qu'illustré sur la figure 5, afin de rendre la distance entre les deux parties (6B) à peu près constante, et ce dans l'objectif d'aboutir à une maximalisation du courant total traversant la structure sans générer de zone ou l'intensité de courant serait sensiblement plus élevée que la moyenne.

Selon l'invention, au moins une ondulation (9) est réalisée dans l'intervalle entre les deux parties (6B), de telle manière que la longueur « électrique » déployée entre ces deux parties soit sensiblement égale à L.

De cette manière, la densité du courant demeure sensiblement constante selon une équipotentielle centrale représentée par le trait fléché de longueur W (W est la largeur « électrique » équivalente).

L'évaluation de la résistance électrique entre les deux limites des zones (6B) dans leur partie sensiblement circulaire s'exprime alors par la relation :

$$\frac{Rs}{2\theta} \cdot \ln \frac{L + r_2}{r_2}$$

où $\theta$ représente l'angle de vue du ou des ondulations à partir de la zone circulaire.

Avantageusement, les ondulations peuvent être poursuivies au niveau d'une ou des zones rectangulaires, sous diverses réserves de masse et de perturbations d'absorption optique, ainsi que signalé précédemment.

La largeur Wp du rectangle de longueur « électrique » L équivalent aux deux zones (8) modifiées selon l'invention est donnée par la relation

$$\frac{RsL}{Wp} = \frac{Rs}{2\theta}.\ln\frac{L+r_2}{r_2} \text{ soit } Wp = 2\theta.L/\ln((L+r_2)/r_2)$$

L'application de deux ondulations idéalement de profil carré de 0,5 $\mu$m d'amplitude à la configuration représentée au niveau de la figure 5 conduit à dessiner un disque central d'environ 2,5 $\mu$m de rayon $r_2$, et un angle $\theta$ égal à $3\pi/2$. Avec une longueur L de 6,5 $\mu$m, selon le dimensionnement exemplifié antérieurement, on aboutit à une largeur Wp = 48 $\mu$m.

Les zones rectangulaires sont réduites d'environ 33 $\mu$m de largeur électrique Wr par suite de l'insertion des zones (8) circulaires, selon l'exemple décrit. La largeur électrique résultante globale W = Wp + Wr étant alors voisine de 80 $\mu$m.

Par rapport à la configuration selon l'état antérieur de la technique de la figure 2, dans laquelle W est voisin de 60 $\mu$m, cette différence représente une amélioration d'environ 15 % de résolution thermique (rapport (80/60)$^{1/2}$), c'est à dire mieux que la configuration idéale selon le trait pointillé de la figure 2. Le surplus de matière nécessaire à la réalisation des ondulations telles que représentées demeure très modéré car localisé aux zones (8) où se manifeste l'effet de pointe décrit en relation avec l'analyse de l'état antérieur de la technique, et n'augmente que marginalement (10% environ) la constante de temps du dispositif.

Il va être décrit ci-après un procédé de réalisation d'un détecteur bolométrique conforme à l'invention.

De manière connue, les matrices de microbolomètre sont réalisées à partir du circuit de lecture de la manière suivante :

- formation d'une couche auxiliaire, dite sacrificielle sur le substrat constitutif du circuit de lecture, notamment en silicium, ladite couche étant destinée à être ôtée par tout moyen connu après réalisation du détecteur, afin de découpler thermiquement le circuit de lecture du module de détection, également appelé partie sensible ;
- formation sur cette couche sacrificielle d'une couche de matériau bolométrique, et des électrodes.

La réalisation de ce bolomètre s'effectue par dépôts et gravures successives à l'aide de procédés traditionnels connus de l'homme du métier, notamment dans le domaine de la microélectronique, de diverses couches constitutives du produit fini (diélectriques, matériau bolométrique, matériaux métalliques pour les zones équipotentielles ou électrodes).

L'ensemble des techniques à mettre en oeuvre est par exemple décrit en détail dans les différents documents mentionnés précédemment. Afin de réaliser l'invention, on forme les ondulations à l'aide de procédés traditionnels de lithographie et de gravure sèche, bien connus de l'homme du métier, sur la surface de cette couche sacrificielle, le plus souvent réalisée en polyimide et d'épaisseur comprise entre 1,5 et 3 $\mu$m, juste avant de déposer le premier matériau constitutif du détecteur bolométrique.

Il est également à la portée de l'homme du métier de définir s'il convient de tracer le contour (9) des ondulations parallèlement ou orthogonalement aux lignes de courant, afin d'ajuster la résistance électrique globale R du dispositif vers les valeurs qui optimisent ou facilitent sa mise en oeuvre en relation avec les contraintes éventuelles générées par la configuration du circuit de lecture, et même utiliser les deux formes simultanément sur le même détecteur bolométrique élémentaire, selon l'espace disponible et la configuration souhaitée des lignes de courant à l'intérieur du dispositif.

A cet égard, il convient de rappeler que l'invention peut être mise en oeuvre uniquement dans ce but d'ajustement de résistance dans un espace donné, par un autre moyen que l'ajustement d'épaisseur, de résistivité, de dispositions des zones équipotentielles (6B).

Ainsi, pour la mise en oeuvre de l'invention selon la configuration de la figure 4, et selon un mode de réalisation préféré, il convient d'insérer un niveau lithographique de définition des ondulations, puis procéder à la gravure partielle de la couche sacrificielle, dans la description du mode de réalisation préféré qui est fournie dans le document FR-A-2 752 299.

Dans le cadre du mode de réalisation décrit en relation avec la figure 5, il est possible selon une première forme de réalisation, de réaliser les ondulations inscrites dans les parties (5), ce qui permet d'éviter de graver le matériau desdites parties (5) dans le relief des ondulations, si ces dernières sont réalisées avant le dépôt de la couche (5). Si le profil de l'ondulation est abrupt, cette opération peut être délicate. Il peut être ainsi avantageux au contraire de dessiner ces ondulations à l'extérieur des parties (5), de manière à ne pas contraindre le matériau diélectrique (7) à une qualité d'isolement élevée à l'intérieur des ondulations. Cette option a été retenue dans le cas du développement qui suit.

Un mode de réalisation avantageux selon la configuration de la figure 5 est décrit ci-après.

A partir d'un substrat, notamment réalisé en silicium, on procède au dépôt d'une couche métallique réfléchissante, et on applique un premier niveau lithographique pour séparer par gravure les motifs du réflecteur.

Il est alors procédé au dépôt et au traitement conventionnel de la couche sacrificielle (1,8 à 2,5 $\mu$m d'épaisseur) typiquement en polyimide. Puis, on procède au dépôt optionnel en surface du polyimide d'un isolant, typiquement de l'oxyde ou d'une nitrure de silicium (10 à 100 nanomètres d'épaisseur).

On procède alors au dépôt de la couche conductrice (5), typiquement du nitrure de titane, afin d'obtenir une résistance de couches de 150 à 400 Ohms, et l'on applique un second masque lithographique et on procède à une gravure de la couche (5) en dégageant les surfaces où seront gravées les ondulations (9).

On procède alors au dépôt d'une seconde couche diélectrique identique ou voisine en épaisseur et en nature de la première, et l'on applique un troisième masque lithographique et l'on grave ces diélectriques selon les surfaces (6B), et également sur les parties (3).

Un quatrième masque lithographique est alors appliqué pour graver dans les couches superficielles et le polyimide, l'empreinte des piliers (3).

On dépose alors un matériau métallique selon les techniques connues, pour former les piliers (3) et l'on applique un cinquième masque lithographique pour graver ce matériau métallique en dehors des parties (3).

Puis on procède à l'application d'un sixième masque lithographique pour définir les ondulations (9) conformes à l'invention, et puis on procède à la gravure des couches diélectriques de la forme des ondes sur 0,5 $\mu$m à 1 $\mu$m typiquement de profondeur (amplitude), dans la couche sacrificielle de polyimide.

Le profil des ondulations est défini par le techniques de détail du masquage et de maîtrise du procédé de gravure, bien connues de l'homme du métier. Le fait de former des ondulations en cours de processus plutôt qu'avant tout dépôt en surface du polyimide présente l'avantage d'éliminer tout ou partie de la masse de matériaux non concernés par les lignes de courant (ici une ou deux couches diélectriques) sur les surfaces concernées par la gravure des ondulations.

On procède alors au dépôt du matériau bolométrique, typiquement mais de manière non limitative, du silicium amorphe ou matériau apparenté du type $Si_xGe_yC_z$ où x, y et z ont une valeur comprise entre 0 et 1, avec x+y+z = 1, ce matériau pouvant être dopé au bore ou au phosphore et s'étendant sur une épaisseur comprise entre 50 à 300 nanomètres.

Le matériau bolométrique peut également être constitué d'oxyde de vanadium ou de mélange d'oxydes de vanadium de compositions diverses (de formule générale VOx).

Un critère important de réussite d'application de la présente invention est le bon recouvrement de l'ondulation par le matériau bolométrique, ce qui peut être obtenu sans difficulté, en particulier avec le silicium amorphe et les matériaux apparentés, synthétisés très généralement par dépôt chimique en phase vapeur (CVD pour *Chemical Vapor Deposition*).

On procède alors à l'application d'un septième niveau de lithographie, pour définir les contours des détecteurs élémentaires, les bras d'isolement thermique (4) et protéger les piliers (3) et gravure de l'ensemble des couches présentes en dehors des piliers (3) jusqu'à la couche sacrificielle. Avantageusement, un niveau lithographique supplémentaire peut être appliqué avant le septième niveau précédent, afin d'éliminer le matériau bolométrique sur la surface correspondant aux parties (3), et ce pour améliorer la résistance thermique.

Le processus de réalisation s'achève par la découpe des substrats en produits finis individuels, et élimination de la couche sacrificielle.

Si l'ordre précis des opérations précédemment indiquées pour obtenir le produit fini n'est pas limitatif, il est en revanche nécessaire de réaliser la texturation, c'est à dire la gravure des ondulations préalablement au dépôt du matériau bolométrique avant l'un de ces dépôts, s'il y en a plusieurs dans le processus.

Les modes détaillés de réalisation de l'invention, selon la configuration de la figure 4 apparaissent de manière simple à l'homme de métier à partir des vues en en plan et en coupe des structures, et à l'aide du procédé décrit précédemment.

La réalisation du motif d'ondulation en creux par rapport à la surface plane de la couche sacrificielle peut également être réalisée en relief. Dans ce cas, et afin d'éviter, notamment s'il est souhaité de réaliser des ondulations de grande amplitude, que les sommets inférieurs des ondulations viennent s'approcher trop près de la surface du circuit de lecture, il suffit alors d'inverser la polarité du dessin du masque lithographique mis en oeuvre, de manière à préserver les parties en relief de l'ondulation finale.

Dans le cas où le bruit basse fréquence (Bbf) constitue un facteur déterminant, le détecteur conforme à l'invention est réalisé de telle sorte que la densité de courant locale soit approximativement constante sur la surface du matériau bolométrique actif (définie par une petite partie des zones 6A), car le bruit serait plus important dans les zones où la densité du courant est plus élevée. C'est la raison pour laquelle les ondulations sont réparties uniformément dans l'espace disponible des parties (6A) sur les figures 3 et 4 et que par ailleurs, l'on a fait dépasser le motif (9) des ondulations sur les limites des parties (5) équipotentielles adjacentes sur la figure 3a. Ces dispositions optimisent le résultat mais ne revêtent pas un caractère obligatoire.

Il convient également dans le cadre de l'invention de limiter les zones pourvues d'ondulation, aux surfaces qui n'ont pas ou peu de fonction d'absorption optique, à moins que l'amplitude D soit faible (typiquement moins de 1 $\mu$m pour un détecteur bolométrique destiné à détecter dans une gamme de longueur d'onde comprise entre 8 et 14 $\mu$m) devant la gamme de longueurs d'onde à absorber, sans quoi, l'absorption des rayonnements pourrait ne pas être optimale.

En outre, réaliser des ondulations sur des surfaces comportant des électrodes (5) notamment des figures 1 et 3, augmenterait inutilement la masse du matériau bolométrique non concerné par les lignes de courant et donc inutile au niveau de la performance de détection.

Enfin, il convient également de maintenir le pas P de l'ondulation nettement en dessous de la longueur d'onde moyenne à détecter, typiquement au plus égal à 3 micromètres, à moins que l'effet diffractif soit délibérément recherché.

On conçoit dès lors tout l'intérêt du détecteur bolométrique conforme à l'invention, dans la mesure où il permet de manière simple, l'optimisation de ses caractéristiques de détection, sans affecter les autres paramètres liés à son fonctionnement, et notamment ceux dictés par le circuit de lecture auquel il est associé.

**Revendications**

1. Détecteur bolométrique comprenant un circuit de lecture (1) formé dans un substrat, au dessus duquel sont disposés :

   - une partie sensible comportant :

      • une ou plusieurs couches (6) d'un matériau sensible, dont la résistivité varie avec la température ;
      • des électrodes (5) isolées les unes des autres faisant en outre fonction d'absorbeur du rayonnement infrarouge, lesdites électrodes étant en contact avec le matériau sensible sur au moins une partie de leur surface;

   - au moins une zone support (3) de la partie sensible, faisant fonction de positionnement de la dite partie sensible et de conducteur électrique en relation avec ledit circuit de lecture (1),
   - au moins une structure d'isolement thermique reliant électriquement et mécaniquement chaque zone support (3) à la partie sensible,

   ***caractérisé:***

      • **en ce que** les zones de matériau sensible non en contact avec les électrodes (5), présentent au moins une ondulation (9) orientée selon la direction perpendiculaire au plan contenant la partie sensible du détecteur bolométrique ;
      • et **en ce que** le matériau sensible bolométrique est constitué de silicium amorphe ou d'un alliage apparenté de type $Si_xGe_yC_z$ où x+y+z=1.

2. Détecteur bolométrique selon la revendication 1, ***caractérisé*** **en ce que** la ou les ondulations (9) sont orientées parallèlement aux lignes de courant qui traversent la partie sensible du détecteur en fonctionnement.

3. Détecteur bolométrique selon la revendication 1, ***caractérisé*** **en ce que** la ou les ondulations (9) sont orientées perpendiculairement aux lignes de courant qui traversent la partie sensible du détecteur en fonctionnement.

4. Détecteur bolométrique selon la revendication 1, ***caractérisé*** **en ce qu'**il comprend plusieurs zones d'ondulations (9) positionnées au niveau de zones différentes, lesdites ondulations étant respectivement orientées parallèlement et perpendiculairement aux lignes de courant qui traversent la partie sensible du détecteur en fonctionnement.

5. Détecteur bolométrique selon la revendication 1, ***caractérisé*** **en ce que** la ou les ondulations (9) sont orientées de manière oblique par rapport aux lignes de courant qui traversent la partie sensible du détecteur en fonctionnement.

6. Détecteur bolométrique selon l'une des revendications 1 à 5, ***caractérisé*** **en ce que** l'amplitude des ondulations (9) est inférieure à la distance séparant les électrodes (5) du substrat constitutif du circuit de lecture (1).

7. Détecteur bolométrique selon la revendication 6, ***caractérisé*** **en ce que** l'amplitude des ondulations (9) est d'au plus 1,5 $\mu$m.

8. Détecteur bolométrique selon l'une des revendications 1 à 7, *caractérisé* **en ce que** le pas ou la périodicité des ondulations (9) est d'au plus trois micromètres.

9. Dispositif de détection infrarouge de type bolométrique, *caractérisé* **en ce qu'**il met en oeuvre un ou plusieurs détecteurs bolométriques selon l'une des revendications 1 à 8, et **en ce que** le ou les détecteurs sont solidarisés au circuit de lecture au moyen d'une structure de type pilier (3).

10. Dispositif de détection infrarouge de type bolométrique selon la revendication 9, *caractérisé* **en ce qu'**il présente une structure matricielle comportant au moins deux détecteurs bolométriques.

11. Procédé pour la réalisation d'un détecteur bolométrique selon la revendication 1, consistant, à partir d'un circuit de lecture, notamment réalisé sur un substrat silicium (1) :

- tout d'abord, à former une première couche auxiliaire sacrificielle sur ledit substrat silicium, destinée à être ôtée par tout moyen connu après réalisation du détecteur afin de découpler thermiquement le circuit de lecture (1) du module de détection ou partie sensible ;
- puis à former sur cette couche auxiliaire sacrificielle, entre autres une couche de matériau bolométrique en silicium amorphe (6) ou en un matériau apparenté de type $Si_xGe_yC_z$ où x + y + z = 1, mais également des électrodes (5), destinées à envoyer des signaux électriques nécessaires au fonctionnement du détecteur bolométrique et à acheminer le signal résultant de la détection du rayonnement infra rouge par ledit bolomètre au niveau du circuit de lecture,

*caractérisé* **en ce que** l'on réalise une gravure localisée de la couche sacrificielle correspondant à la forme souhaitée d'ondulations (9) préalablement au dépôt du matériau bolométrique, cette gravure étant réalisée dans les zones où les électrodes (5) ne sont pas en contact avec le matériau bolométrique (6).

**Claims**

1. Bolometric detector comprising a read circuit (1) realised in a substrate, and above which are disposed :

- a sensitive part having:

• one or more layers (6) of a sensitive material, the resistivity of which varies with temperature;
• electrodes (5) isolated from one another, also acting as infrared radiation absorber, the said electrodes being in contact with the sensitive material over at least part of their surface;

- at least one support region (3) for supporting the sensitive part, acting so as to position the said sensitive part, and acting as an electrical conductor, in relation to said read circuit (1) ; and
- at least one thermal insulation structure electrically and mechanically connecting each support region (3) to the sensitive part,

*characterized:*

- **in that** the regions of sensitive material not in contact with the electrodes (5) have at least one corrugation (9) oriented along the direction perpendicular to the plane containing the sensitive part of the bolometric detector; and
- **in that** the bolometric sensitive material consists of amorphous silicon or a related alloy of the $Si_xGe_yC_z$ type in which x + y + z = 1.

2. Bolometric detector according to Claim 1, *characterized* **in that** the corrugation or corrugations (9) are oriented parallel to the current lines that pass through the sensitive part of the detector when in operation.

3. Bolometric detector according to Claim 1, *characterized* **in that** the corrugation or corrugations (9) are oriented perpendicular to the current lines that pass through the sensitive part of the detector when in operation.

4. Bolometric detector according to Claim 1, *characterized* **in that** it comprises several regions of corrugation (9) that are positioned in different areas, the said corrugations being respectively oriented parallel and perpendicular to the current lines that pass through the sensitive part of the detector when in operation.

5. Bolometric detector according to Claim 1, *characterized* **in that** the corrugation or corrugations (9) are oriented obliquely relative to the current lines that pass through the sensitive part of the detector when in operation.

6. Bolometric detector according to one of Claims 1 to 5, *characterized* **in that** the amplitude of the corrugations (9) is less than the distance separating the electrodes (5) from the constituent substrate of the read circuit (1).

7. Bolometric detector according to Claim 6, *characterized* **in that** the amplitude of the corrugations (9) is at most 1.5 μm.

8. Bolometric detector according to one of Claims 1 to 7, *characterized* **in that** the pitch or periodicity of the corrugations (9) is at most three microns.

9. Bolometric-type infrared detection device, *characterized* **in that** it employs one or more bolometric detectors according to one of Claims 1 to 8, and **in that** the detector or detectors are fastened to the read circuit by means of a pillar-type structure (3).

10. Bolometric-type infrared detection device according to Claim 9, *characterized* **in that** it has an array structure comprising at least two bolometric detectors.

11. Process for producing a bolometric detector, consisting, starting with a read circuit, particularly one produced on a silicon substrate (1):

- firstly in forming a first sacrificial auxiliary layer on the said silicon substrate, the said layer being intended to be removed by any known means after the detector has been produced, so as to thermally decouple the read circuit (1) from the detection module or sensitive part;
- secondly in forming, on this sacrificial auxiliary layer, among other layers a layer of bolometric material made of amorphous silicon (6) or of a related material of the $Si_xGe_yC_z$ type in which $x + y + z = 1$, but also electrodes (5) intended for sending electrical signals needed to operate the bolometric detector and for conveying the signal resulting from the detection by the said bolometer of the infrared radiation to the read circuit,

*characterized* **in that** the sacrificial layer is locally etched so as to correspond to the desired shape of the corrugations (9) before the bolometric material is deposited, this etching being carried out in the regions in which the electrodes (5) are not in contact with the bolometric material (6).

**Patentansprüche**

1. Bolometrischer Detektor, umfassend einen Lesekreis (1), der in einem Substrat gebildet ist, über dem angeordnet sind:

- ein empfindlicher Teil, umfassend:

  . eine oder mehrere Schichten (6) aus einem empfindlichen Werkstoff, dessen spezifischer Widerstand sich mit der Temperatur ändert;
  . voneinander isolierte Elektroden (5), die außerdem einen Infrarotabsorber bilden und die mindestens auf einem Teil ihrer Oberfläche mit dem empfindlichen Werkstoff in Kontakt sind;

- mindestens eine den empfindlichen Teil tragende Zone (3), die eine Positionierung des empfindlichen Teils und einen elektrischen Leiter in Verbindung mit dem Lesekreis (1) bildet,
- mindestens eine Wärmeisolationsstruktur, die jede Tragzone (3) elektrisch und mechanisch mit dem empfindlichen Teil verbindet,

**dadurch gekennzeichnet,**
**dass** die Zonen des empfindlichen Werkstoffs, die nicht mit den Elektroden (5) in Kontakt sind, mindestens eine Wellung (9) aufweisen, die in der
Richtung gerichtet ist, die zu der den empfindlichen Teil des bolometrischen Detektors enthaltenden Ebene senkrecht ist;

■ und dass der empfindliche bolometrische Werkstoff aus amorphem Silicium oder einer verwandten Legierung vom Typ $Si_xGe_yC_z$ besteht, worin x + y + z = 1.

2. Bolometrischer Detektor nach Anspruch 1, **dadurch gekennzeichnet, dass** die Wellung oder die Wellungen (9) parallel zu den Stromlinien gerichtet sind, die den empfindlichen Teil des Detektors im Betrieb durchqueren.

3. Bolometrischer Detektor nach Anspruch 1, **dadurch gekennzeichnet, dass** die Wellung oder die Wellungen (9) senkrecht zu den Stromlinien gerichtet sind, die den empfindlichen Teil des Detektors im Betrieb durchqueren.

4. Bolometrischer Detektor nach Anspruch 1, **dadurch gekennzeichnet, dass** er mehrere Zonen von Wellungen (9) umfasst, die auf Höhe von verschiedenen Zonen positioniert sind, wobei diese Wellungen parallel bzw. senkrecht zu den Stromlinien gerichtet sind, die den empfindlichen Teil des Detektors im Betrieb durchqueren.

5. Bolometrischer Detektor nach Anspruch 1, **dadurch gekennzeichnet, dass** die Wellung oder die Wellungen (9) schräg zu den Stromlinien gerichtet sind, die den empfindlichen Teil des Detektors im Betrieb durchqueren.

6. Bolometrischer Detektor nach einem der Ansprüche 1 bis 5, **dadurch gekennzeichnet, dass** die Amplitude der Wellungen (9) kleiner als der Abstand der Elektroden (5) von dem den Lesekreis (1) bildenden Substrat ist.

7. Bolometrischer Detektor nach Anspruch 6, **dadurch gekennzeichnet, dass** die Amplitude der Wellungen (9) höchstens 1,5 μm beträgt.

8. Bolometrischer Detektor nach einem der Ansprüche 1 bis 7, **dadurch gekennzeichnet, dass** der Schritt oder die Periodizität der Wellungen (9) höchstens drei Mikrometer beträgt.

9. Bolometrische Infrarot-Erfassungsvorrichtung, **dadurch gekennzeichnet, dass** sie einen oder mehrere bolometrische Detektoren nach einem der Ansprüche 1 bis 8 benutzt und dass der oder die Detektoren mit Hilfe einer Säulenstruktur (3) mit dem Lesekreis fest verbunden sind.

10. Bolometrische Infrarot-Erfassungsvorrichtung nach Anspruch 9, **dadurch gekennzeichnet, dass** sie eine Matrizenstruktur aufweist, die mindestens zwei bolometrische Detektoren umfasst.

11. Verfahren zur Herstellung eines bolometrischen Dektektors nach Anspruch 1, das darin besteht, dass, ausgehend von einem insbesondere auf einem Siliciumsubstrat (1) gebildeten Lesekreis,

- zunächst auf dem Siliciumsubstrat eine erste zusätzliche Opferschicht gebildet wird, die dazu bestimmt ist, nach Herstellung des Detektors durch jedes beliebige bekannte Mittel entfernt zu werden, um den Lesekreis (1) vom Erfassungsmodul oder empfindlichen Teil thermisch abzukoppeln;
- dann auf dieser zusätzlichen Opferschicht unter anderen eine Schicht aus einem bolometrischen Werkstoff aus amorphem Silicium (6) oder aus einem verwandten Werkstoff vom Typ $Si_xGe_yC_z$ gebildet wird, worin x + y + z = 1, aber auch Elektroden (5), die dazu bestimmt sind, für den Betrieb des bolometrischen Detektors erforderliche elektrische Signale zu senden und das Signal, das sich aus der Erfassung der Infrarotstrahlung durch das Bolometer ergibt, zum Lesekreis zu leiten,

**dadurch gekennzeichnet, dass** man vor dem Auftrag des bolometrischen Werkstoffs eine örtliche Gravur der Opferschicht vornimmt, die der gewünschten Form der Wellungen (9) entspricht, wobei diese Gravur in den Zonen vorgenommen wird, in denen die Elektroden (5) nicht mit dem bolometrischen Werkstoff (6) in Kontakt sind.

Coupe AA

Figure 1

**Coupe AA**

**Figure 2**

Coupe AA   Coupe BB

Fig. 3A

Fig. 3B

Coupe CC

**Coupe AA**

**Figure 4**

Figure 5

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5021663 A
- FR 2752299 A
- FR 2796148 A
- US 5367167 A